# EUROPEAN PATENT SPECIFICATION

(11) **EP 2 898 535 B1**
(45) Date of publication and mention of the grant of the patent: **10.01.2018**
(21) Application number: 13839348.3
(22) Date of filing: 19.09.2013
(51) Int. Cl.: H01L 31/02

(54) **AN ARRANGEMENT FOR CONTROLLING A POWER SOURCE SYSTEM**
ANORDNUNG ZUR STEUERUNG EINES STROMQUELLENSYSTEMS
AGENCEMENT DE RÉGULATION D'UN SYSTÈME DE SOURCE D'ALIMENTATION

(30) Priority: 19.09.2012 FI 20125963
(43) Date of publication of application: 29.07.2015
(73) Proprietor: Ecoeco Oy, 20660 Kaarina (FI)
(72) Inventor: BERZINS, Aleksandrs, LV-2160 Saulkrasti Saulkrastu novads (LV); ZABLOCKIS, Harijs, LV-1009 Riga (LV)
(74) Representative: Heinonen & Co
(86) International application number: PCT/FI2013/050906
(87) International publication number: WO 2014/044913

(56) References cited:
- WO-A1-2011/070548
- WO-A2-2012/075172
- DE-A1- 3 010 371
- JP-A- 2008 198 829
- US-A1- 2008 306 700
- US-A1- 2010 085 063
- US-A1- 2011 316 343
- US-A1- 2012 098 344
- US-A1- 2012 161 801

## Description

### Technical field

Generally, the present invention relates to an arrangement for controlling a power source system. More specifically, the present invention relates an arrangement for controlling power source elements in a power source system.

### Background technology

Nowadays, a lot of various energy harvesting systems are available. For example, photovoltaic, wind, water, moisture, vibration and thermal energy harvesting equipment can be exploited both in small and large scale energy production. The size of the power source system can vary from one power source element, such as solar panel, to an array of power source elements, such as photovoltaic energy harvesting components possibly comprising various types of elements. Furthermore, the power source systems can be e.g. a standalone, portable, mobile and/or automotive system having no connection to mains grid or grid- connection enabled to feed the power to the grid. Documents US2012161801A and JP2008198829A describe means to monitoring power generating devices. In addition, a lot of articles, such as cameras and toys or electric / hybrid vehicle, require rechargeable or non-rechageable batteries or battery packs in order to function. A battery discharge balancing may cause problems, if the energy level of batteries varies too much within a system. Due to this we are throwing away as much as 1/5th of a battery sometimes, which forms a huge amount of wasted energy.

It is commonly known that e.g. photovoltaic cells are extremely sensitive to extrinsic factors, such as shading and/or stains on the surface. Typically, when even a small portion of an entity, such as cell, module or array, is shaded, while the remaining entity is in sunlight, the output of the entity falls dramatically due to increase of internal resistance. In that case, the energy from the other photovoltaic cells may be lost due to the shaded component. The prior art knows solutions to reduce the problem of dropping of the output level, such as bypass diodes between each cell, but, unfortunately, these solutions are quite ineffective and components, such diodes, might easily suffer from electric breakdown, when the voltage difference between cells increases too much. In addition, a voltage drop caused by diodes itself generates power loss and excessive heat in the system. Together with ambient heat, the diode heat may degrade the system shortening its lifespan.

Broadly speaking, the above described problems also apply to power source systems comprising other power source elements than energy harvesting components. Having one or more weaker power source elements among series and/or parallel-connected elements cause energy lost in the system due to same reason as described above.

The cost of solar panels has decreased as the techniques for manufacturing solar panels and components have improved. Therefore, the photovoltaic energy harvesting system becomes more efficient way to produce energy both in households and power parks. Ideally, the panels should be oriented to sun to maximize the efficiency of photovoltaic conversion. For static system, the best orientation of panels is towards south. It will give the best average performance as sun travels from rise to set.

Unfortunately, there is always the shading problem with these solar panels in the system. When setting up solar panels, user has to consider all kind of matters; an optimal place for solar panel in the morning may be partly shaded by a tree in the afternoon, for example. This reduces possible locations and positions for solar panels, which makes the deployment of the solar panels a difficult and complicated process.

The prior art knows systems capable of tracking the photovoltaic panels to azimuth and elevation of the energy source, i.e. the sun. These systems might have issues with complexity, high costs, comparably weakened support structures and potential energy loss due to tracking sensor or algorithm malfunction. Furthermore, these systems may normally have quite a long response time, e.g. from tens of seconds to tens of minutes, which may increase their ineffectiveness.

### Summary of the invention

The purpose of the present invention is to avoid or reduce the above disadvantages of the prior art.

The object of the invention is achieved with a solution, wherein a power source system to be controlled by an arrangement according to the present invention is divided into a number of parallel and/or series connected power source elements, which energy level of a power source element is monitored in real time and energy provided by the power source element is transferred, if the energy level in the power source element exceeds a threshold value.

An arrangement for controlling a power source system according to the present invention is characterized by the features of claim 1.

According to one embodiment of the present invention the arrangement for controlling a power source system comprises a number of cell modules, which cell modules are functionally connected to power source elements of the power source system, and control means for controlling energy transfer from power source elements, which control means comprise real time monitoring means for monitoring energy level in a power source element and means for synchronizing and converting energy provided by a power source element, wherein the control means are arranged to obtain the information related to the energy level in a power source element and perform the energy transfer from a power source element, if the energy level in the power source element exceeds a threshold value.

In one embodiment, a power source element can be selected from the group consisting of energy storing and converting elements, such as a rechargeable battery/ batteries, a non-rechargeable battery/batteries, supercapacitor/supercapacitors, ultracapacitor/ultracapacitors, an energy harvesting unit/units based on energy harvesting from wind, sun, moisture, electromagnetic field, vibration, heat, fluid flow, mechanical motion and/or rotation or any combination of but not limited to listed above.

In another embodiment, a power source element of a photovoltaic element is selected from group consisting of a solar panel, string of elements in a solar panel, one or more cells in string of a panel, one or more micro-cell of a cell in a solar panel.

In one embodiment, the threshold value of the energy level corresponds to energy consumption relating to a power source element comprising energy needed for supervisory of given power source element and/or conversion. Preferably, the threshold value is selected to be greater than or at least same as the self-consumption of a power source element.

In one embodiment, the energy transfer from a power source element is proceeded as long as the energy level in the power source element exceeds the threshold value. In another, embodiment, the energy transfer from a power source element is proceeded a predetermined time period, if the energy level in the power source element exceeds the threshold value.

Yet, in another embodiment, numerous power source elements in said arrangement are used as a power source sensor. In case of a solar tracking system, light source (sun) can be tracked by using PV cells as light sensor. In case of other types of energy harvesting respective energy source can be tracked. In this way, it may be possible to implement a reliable and fast tracking system by using power source elements and measuring information thereof. It may also be possible to utilize the tracking system according to the present embodiment to distinguish clouds from the movement of the sun or other obstacles, preventing harvesting system from full power operation. Detection of damaged power source elements as well as early failure warning system is also possible. For instance, it might be possible to tell early, when one of batteries in system starts to lose the capacity, in case of rechargeable batteries.

Some preferable embodiments of the invention are described in the dependent claims.

Significant advantages can be achieved with the present invention when compared to the prior known solutions. The arrangement according to the present invention is arranged to observe the whole system together and every circuit is integrated in a single synchronous power conversion machine, which may maximize the whole system efficiency, not only separate parts of it. The arrangement may enable fast and efficient controlling of a power source system, and it may improve the overall harvested energy for energy harvesting equipment by maximizing its output capacity.

The present invention is versatile; it may be exploited for controlling different power source systems comprising various power source elements arranged to both convert and harvest energy. It may be suitable arrangement for private cottages, remote data gathering systems, remote process controls, and telecommunication power supplies, lighting and small to medium energy harvesting stations. The present invention is also suitable for using in several different energy requiring articles, such as toys, cameras, phones, in automotive, as electric and hybrid vehicles, to name a few.

The arrangement of the present invention is scalable, which may allow the user to implement his or her energy harvesting equipment applying the current times best price/performance ratio. Furthermore, the integration level of the arrangement according to the present invention is selectable and the efficiency of the energy harvesting equipment according to the present invention may increase when selected higher integration level.

The present invention may help to maintain a better battery discharge balancing for both rechargeable and non-rechargeable battery stack and multicell rechargeable batteries, which may help to improve their potential.

In addition, when using the present invention in connection with e.g. a solar power source system, the present invention may enable setting up of the photovoltaic energy harvesting equipment so that all photovoltaic cells may not need to be in an optimal location and/or position, but less optimal locations and/or positions may also be suitable. This may enable the energy harvesting equipment to be expanded to a wider geographical area.

Furthermore, the arrangement according to the present invention may enable usage of power sources elements as a tracking system in a photovoltaic energy harvesting system, which may provide fast and reliable tracking system for the photovoltaic energy harvesting system. Usage of the present invention may enable tracking of the sun without using external sensors. The present invention may also provide statistics of multiple issues, such as degradation, cleanness, efficiency and overall health of the power source elements in the system, such as, but not limited to, photovoltaic elements, for each separate power source element in the system.

The system of the present invention may enable to perform maximum power-point tracking with the local power point detection very fast, such as e.g. in seconds or even tens of milliseconds. This feature may enable taking pictures of clouded sky and regenerate the cloud images by using a solar panel array of the system as a huge camera sensor matrix.

The expression "power source element" refers herein to any element arranged to deliver energy, which element can be energy storing, converting and/or harvesting element, such as, but not limited to a rechargeable battery/ batteries, a non-rechargeable battery/batteries, supercapacitor/supercapacitors, ultracapacitor/ultracapacitor, an energy harvesting unit/ units based on energy harvesting from wind, sun, moisture, electromagnetic field, vibration, heat, fluid flow, mechanical motion and/or rotation or any combination of but not limited to listed above. The size of the element can vary as well as the amount of energy stored/generated/harvested in the element. The power source element can also be composed of several distinct units forming together an entity, such as a panel of energy harvesting elements, such as solar panel, string of energy harvesting elements, such as string of elements in a solar panel, one or more energy harvesting elements, such as photovoltaic cells in string of a solar panel, one or more micro-cell in an energy harvesting element, such as micro-cell of a cell in a solar panel.

The expression "photovoltaic energy harvesting equipment" refers herein to any implementation of systems and devices and the possible combination thereof used for converting sunlight into energy.

The expression "PV entity" refers herein to PV elements that together form some physical ensemble, such as a solar panel.

### Short description of the drawings

Next, the invention is described in more detail with reference to the appended drawings, in which
Fig. 1 illustrates an exemplary schematic view of an embodiment of the present invention;
Fig. 2 illustrates an exemplary structure of an energy transfer from a power source element according one embodiment of the present invention;
Fig. 3 depicts an exemplary schematic view of an inverter module of the arrangement according to an embodiment of the present invention;
Fig. 4 depicts an exemplary schematic view of a monitoring and control module of the arrangement according to an embodiment of the present invention;
Fig. 5 illustrates an exemplary graphical presentation of shaded and damaged power source elements in the network;
Fig. 6 illustrates an embodiment of the energy harvesting process performed by the arrangement for controlling a power source system according to the present invention;
Figs. 7a-7d illustrate exemplary implementation levels according to various embodiments of the present invention.

### Detailed description of the embodiments

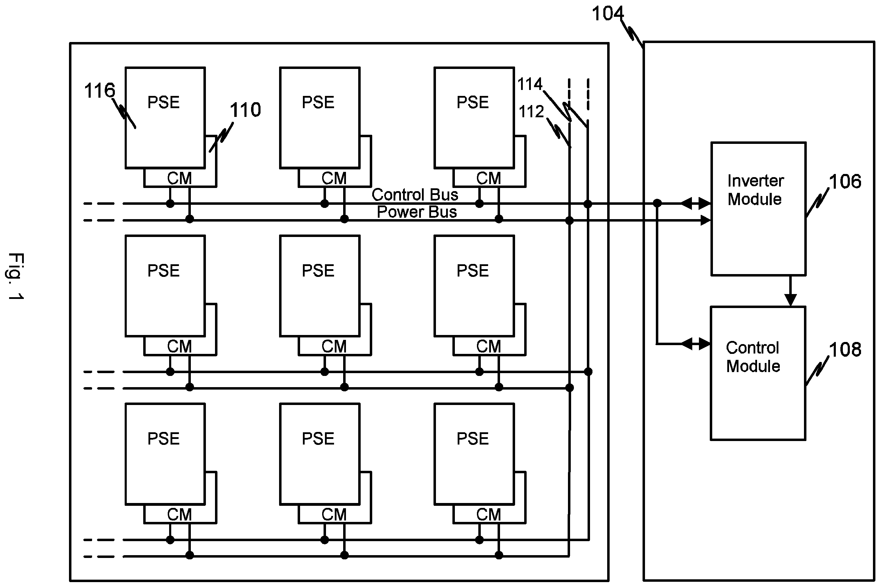

Fig. 1 illustrates an exemplary schematic view of an embodiment of the present invention. An arrangement for controlling a power source system comprises number of serially connected power source elements 116 (assigned with PSE in Fig 1), cell modules 110, which are functionally connected to the power source elements, for transferring energy from power source elements 116, and control means 104 for controlling the energy transfer.

The power source system, controlled by the arrangement according to the present invention, comprises one or more power source elements 116, which can be energy storing, converting and/or harvesting elements, but each power source element is arranged to provide electric energy, which is transferred from the elements in the power source system.

In cases, where one power source element comprises more than one energy units, the energy units within a power source element are preferably connected in series, but in some embodiments the energy units are connected in some other way. The power source elements 116 in the power source system are parallel and/or series connected forming a network of power source elements. The network of power source elements comprises at least two power source elements and the number of the power source elements in the network is not limited by any means. It will be obvious to those skilled in art that the network of power source elements can be composed of one or more power source system having one or more power source types in it.

A power source element 116 is the smallest unit in the network. The power source element 116 comprises at least one energy unit, such as a photovoltaic element (hereafter referred as "PV element",). Each power source element 116 is connected to at least one cell module 110 (referred in Fig. 1 with capital letter CM) so that the energy transfer from the power source element 116 can be performed by means of the cell module 110. In one embodiment, each power source element 116 is tracked separately in real time so that the energy level in the power source element 116 is measured in order to decide if the energy will be transferred from the power source element. Cell modules 110 in the arrangement are connected to control bus 112 for synchronous power switch control, measurement and transfer. Further, each cell module 110 is connected to power bus 114 for transferring energy from the respective power source element 116.

The power source elements 116 can be parallel connected, series connected or a combination thereof, because the energy harvesting from each power source elements is performed via the cell module to which the power source element is connected, and the arrangement is arranged to switch between the cell module regardless of the connection type of the power source elements.

The power unit in a power source element 110 can be of any available size, voltage, amperage, energy capacity, converting and/or harvesting component, such as a PV cell. According to one embodiment, the PV element is one or more micro-cells of PV cell in a PV entity. In another embodiment, the PV element is one or more cells in a PV entity, and in another embodiment, the PV element is one or more element in a string in a PV entity. Yet, in another embodiment, the PV element is one or more strings of elements in the PV entity, and in another embodiment, the PV element is one or more PV entity. The skilled person will appreciate that photovoltaic harvesting equipment can comprise a combination of the PV elements according to various embodiments mentioned above. However, actual implementation of the arrangement according to the present invention will slightly vary depending on size of a PV element. Each implementation architecture will be discussed in greater detail below. It is also obvious to a person skilled in the art that another type of energy harvesting elements can also be arranged to various combinations of components, which will form a power source element.

In one embodiment, as can be seen in Fig. 1, the control means 104 of the arrangement comprise an inverter module 106 for inverting energy transferred from the power source elements 116 and/or charging the arrangement if required, and a control module 108 for monitoring and controlling the arrangement. All cell modules 110 in the network as well as inverter module 106 in control means 104 are mutually connected to the control module 108 via control bus 112. Respectively, the cell modules 110 are connected to the inverter module 106 via power bus 114 for energy transfer from the power source elements 116 to the inverter module 106.

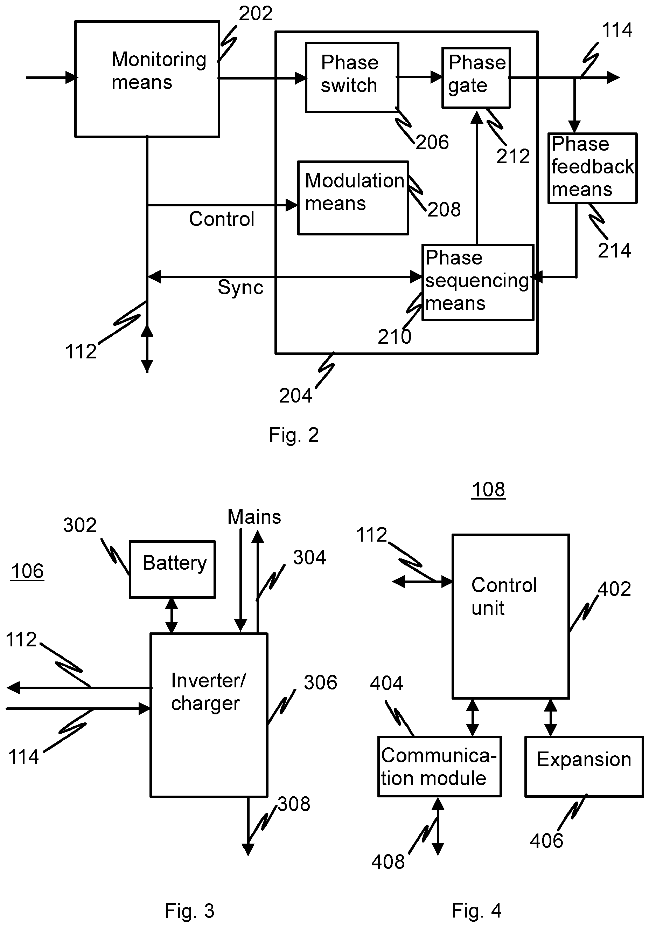

Fig. 2 illustrates an exemplary structure of an energy transfer from a power source element according to one embodiment of the present invention. Exemplary relations between components in the cell module and a travel direction of signal are presented in Fig. 2 with lines and arrows. In one embodiment, the cell module is connected to monitoring means 202 and synchronizing means 204 for monitoring the energy level in the corresponding power source element and for energy transfer from the power source element. In one embodiment, the monitoring means 202 and the synchronizing means 204 are disposed in the control module 108. In another embodiment, the monitoring means are disposed in a cell module so that each cell module comprises its own monitoring means and the information of the energy level in the power source element is provided to the control module via control bus.

The monitoring means 202 for monitoring energy production can comprise, for example, but not limited to, means for measuring current and/or voltage, such as voltmeter, ammeter and/or multimeter, or some other suitable detector(s)/meter(s). In one embodiment, the real time measurement of the energy level in a power source element comprises simultaneous voltage and current measurements. In another embodiment, the real time measurement of the energy level in a power source element comprises voltage or current measurements, and yet in another embodiment, voltage and current measurements are performed alternately. The measuring of the energy level in the power source element is preferably started before the energy transfer, i.e. synchronization, and the measuring continues during the energy transfer. In some embodiment, the measuring is performed periodically, e.g. measuring the energy level every 2 - 20 s, preferably every 5 - 10 s. Depending on power source elements in the power source system, the measurement can also be performed more often, e.g. every 1 ms - 1 s or in microseconds or faster for higher integration levels in future designs.

Depending on the threshold value, the synchronization of the power source element is performed, if the energy level in the power source element exceeds the threshold value. Typically, the threshold value is selected so that the energy transfer is performed, if the energy level in the power source element exceeds or is at least the same as the energy consumption relating to the power source element. That is, the energy level in the power source element should cover at least energy needed for measuring the energy level, supervising the power source element and energy transfer, transferring and/or converting the energy from the power source element. Advantageously, the energy transfer is halted, when the energy level in the power source element drops below the threshold value. In some embodiments, the energy transfer is performed in particular time period, e.g. 1 - 5 min. This embodiment can be advantageous, if the power source system comprises batteries, for example.

In another embodiment, the energy level in a system comprising e.g. batteries is maintained in a better balance by taking an amount of energy from the stacked battery in a proportion to its charge, so they discharge not with even current but with even percentage of charge.

In a preferable embodiment, the threshold value is calculated for each transferring phase, i.e. at each energy transferring cycle the threshold value is measured and calculated again. Thus, the threshold value, the transferring time and the transferring energy can vary in each transferring cycle.

It should be obvious for a person skilled in the art that the energy level of power source elements storing energy like non-chargeable batteries does not need to be checked periodically, when the energy level of that kind of power source element has drop below the threshold value, because they will not get fuller, unless they are changed. On the other hand, the energy level of a power source element may require a periodical check, in cases where the energy level has previously been below the threshold value and the power source elements comprises energy harvesting components.

Synchronizing means comprises electronic components suitable for synchronizing the output of the power source element with outputs of the other power source elements in the network, which synchronizing means 204 are controlled by control means. The synchronization procedure can be implemented in several different ways. In one embodiment, the synchronization procedure is implemented with a power switch control, and in another embodiment the mentioned electronic components for synchronization can comprise, but are not limited to, e.g. a phase switch 206, such as FET polyphase switching regulator, some modulation means 208 for pulse modulation, phase sequencing means 210 for polyphase power mixing, and a phase gate 212. In addition, the synchronizing means 204 can comprise an optional phase feedback means 214, such as, but not limited to, an analog or digital filter. A person skilled in the art will appreciate that the synchronizing means can be implemented by using some other components or the synchronizing means can comprise some auxiliary and/or alternative components.

In one embodiment, the used modulation means 208 can utilize some known technique, such as a spread spectrum technique, and in some other embodiment, the technique used for pulse modulation can be e.g. a pulse-phase modulation. It is obvious for a person skilled in the art that other suitable techniques can also be used for pulse modulation. Depending on embodiments, the synchronization means can also comprise a converting means, such as buck converter, boost converter, SEPIC converter, flyback converter, forward converter, and buck-boost converter or any mix of any architectures of switching regulator, to best fit each power source in the network, if power sources are not same.

Fig. 3 depicts the inner structure of the inverter module 106 of the arrangement according to an embodiment of the present invention. In one embodiment, the inverter module 106 comprises an inverter and/or charger 306, which inverter/charger 306 is typically connected to a battery 302 and/or to mains grid 304. The inverter module 106 takes the mixed energy from the power bus and synchronizes it with and/or injects it to the battery 302 and/or mains grid 304. In one embodiment, the inverter module 106 further comprises a charge controller and/or a mains inverter. In other embodiments, the inverter module 106 comprises either charge controller or mains inverter.

Typically, the inverter module 106 takes its own supply voltage from the battery 302 and/or from the grid 304. The inverter module 106 may also distribute power 308 for the control module and to the other optional modules displaced in connection with the control module. In case of all power source elements in the network are excluded, the inverter/charger 308 may power up the arrangement by using power from mains 304. That can happen during night time in cases where power source elements comprise photovoltaic elements, for example. Preferably, in this case the arrangement switches to a power saving mode and only periodically checks the availability of the power source elements.

Fig. 4 depicts one embodiment of the control module 108 of the arrangement according to an embodiment of the present invention. The control module 108 comprises a control unit 402 comprising e.g. previously described monitoring means and synchronizing means. The control unit 402 may optionally be connected to a communications module 404 for communications with other arrangement and/or devices, e.g. other power source systems, such as photovoltaic energy harvesting equipment arrangements, via PC, Network, Ethernet, WiFi, GSM / satellite phone network and/or modem, for example, and other expansion modules 406, such as, loggers, automation PLCs, smart home interfaces, building management system, SCADA interfaces, geolocation like GPS / GLONAS, burglar alarm, status monitoring, auxiliary sensors, weather station interface, power source tilt, rotation and/or tracking control to name a few examples. The communication between the other arrangements and/or devices is presented in Fig. 4 with two-headed arrow 408. The control bus 112 is connected to the control unit 402 for synchronizing and/or controlling and/or, depending on embodiment, measuring purposes.

The tracking and/or synchronization of the power source elements are typically performed by the control module 108 in control means 104 of the arrangement according to the present invention. Typically, the control module 108 has means normally used in synchronization and/or filtering of the power source elements, such as a software and/or algorithms, which software and/or algorithms may be realized via one or more co-operative software applications or logic modules divided between one or more processing means such as microprocessors, microcontrollers or FPGAs and storage means for the computer program/software/logic configuration and/or e.g. measurement or control data, which storage means can be e.g. non-volatile memory, such as PROM, EEPROM or flash memory, for instance. Also volatile memory such as RAM may be included, especially with back-up including time-keeper, or, for example, RTC integrated RAM or external RAM can also be used.

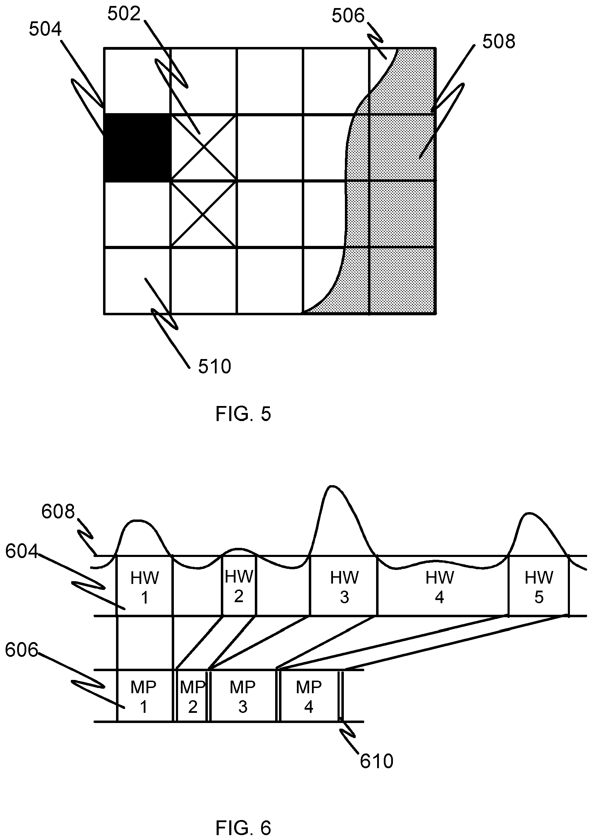

The software and/or algorithms used in the present invention should implement features, such as logging, data acquisition, real-time control, configuration, functionality analysis and/or failure prediction of the arrangement of the present invention. In one additional embodiment, the software and/or algorithms may further provide features, such as graphical representation of cell area, which may provide a possibility for a user to analyze and predict effective factors, such as weather influences and problematic areas caused by e.g. shading or damages, for example. In Fig. 5 is depicted an exemplary graphical presentation of shaded and damaged power source elements in the power source system network. In the graphical presentation, the power source elements are presented as a grid 510 and the presentations can present e.g. damaged cell/cells 502, cell/cells not present 504, partially shaded cell/cells 506 and/or fully shaded cell/cells 508, in cases where the power source elements are photovoltaic elements, for example. In one embodiment, the software and/or logic implementation can be arranged to show a graphical representation of percentage of power harvested from each cell, wherein 100% can act e.g. as a reference to either theoretical max output of the power source element or best logged output of the power source element for given previous period of its usage.

In a preferred embodiment, processing means comprises an integrated circuit such as a field-programmable gate array (FPGA) for implementing the real-time filter for synchronization and/or tracking feedback from the power source elements. In another embodiment, the processing means comprises some appropriate high productivity digital signal processing (DSP) processor. The usage of FPGA is advantageous, because it usually has faster response time than DSP processors, which is required in dynamic phase synching used in the present invention. A person skilled in the art will appreciate that other appropriate parallel logic can be used as processing means.

In Fig. 6 is illustrated an embodiment of the energy harvesting process performed by the arrangement for controlling a power source system according to the present invention. The energy harvesting process of the present invention is called Dynamic Polyphase Power Mixing (DPPM). In the present invention, every power source element is integrated, via the respective cell module, in a single synchronous power conversion machine. In the other words, multiple power source elements are connected to a single converter with many inputs and those multiple inputs of the converter are tracked and regulated at the same time, while still regulating the output of the converter.

In the present invention, the switching between the inputs is implemented dynamically depending on the voltage and current level of inputs, so that inputs having enough energy to be stored are converted one by one. The energy of a power source element is harvested, by means of cell module, during a mix phase 606 (denoted with capital letter MP in Fig. 6), i.e. one cell module is connected to synchronizing means at a time, and the energy of the power source element is transferred, if the energy level in the power source element exceeds the threshold value, which is typically the amount of energy required for conversion.

Thus, the time of the energy transferring phase for each power source element may vary depending on the amount of the energy in a particular power source element. Preferably, the arrangement is arranged to maintain a mutual percentual balance between the power source elements, e.g. by preferring power source elements having more power than the other.

Furthermore, the switching frequency between each phase may vary. Typically, the switching frequency is about tens of kHz to few MHz, but it should be understood that Higher the energy levels in power source elements are, slower the system will have to be.

The advantage of synchronizing one cell module at a time is that the power source element(s) comprising higher energy level does/do not feed the other power source elements/units that have lower energy level, and which would decrease the system efficiency. Power source elements having energy level lower than the threshold value are discarded in the mixing phase. Anyway, other inputs are switched off while one input is handled, as described above.

As described above, depending on embodiment, the monitoring means for monitoring the energy level in a power source element can be placed in each cell module and/or in the control module. Monitoring of the energy level in the synchronized power source element is performed in real time and the monitoring is preferably continued as long as the synchronization continues. In another words, in one embodiment the synchronization, i.e. the energy harvesting, is performed as long as the energy level in the synchronized power source element exceeds the threshold value, and in another embodiment, the synchronization is performed in a predetermined time period, if the energy level in the synchronized power source element remains above the threshold value. In the latter embodiment, the synchronization is advantageously halted before the time limit, if the energy level in the synchronized power source element drops below the threshold value. The length of harvesting windows 604 (denoted with capital letter HW) varies in Fig. 6 representing the varying harvesting time of each power source element.

Because each power source element can comprise different energy level, the output energy of synchronized power source elements may vary, e.g. due to weather condition and other obstacles, such as shading and/or dirt of PV cell. Thus, the energy output per switch cycle may vary between zero and peaking maximum. The minimum harvestable energy level 608 is denoted in Fig. 6 with a line for representing fluctuation in energy producing between different harvest windows. For example, in harvest window 2 is presented a situation, where the synchronized power source element comprises e.g. partially shaded PV elements, and in harvest window 4 is presented a situation, where all PV elements of the power source element are shaded. Unlike presented in Fig. 6, in a preferable embodiment, the harvesting window 604 is short, if the synchronized power source element does not fill the energy level requirement, and next mix phase will be started as soon as possible right after a safety gap 610, which is disposed between every mixing phase 606 in order to protect the switches and/or power sources between synchronized power source elements.

Next, the implementation architecture is discussed. As the arrangement of the present invention is scalable, as discussed above, there can be various ways of hardware implementations for power source systems and actual energy harvesting device sets, standalone devices and/or semiconductor devices. The higher level the integration goes, more efficient the system will be. It is obvious to a person skilled in the art that there can be more integration levels than described below and an arrangement may comprise a combination of different integration levels. In addition, it is obvious to a person skilled in the art that the power source elements described below can comprise another power source elements than PV-cells, although the exemplary implementations are described by using the PV-cells and solar panels as an example.

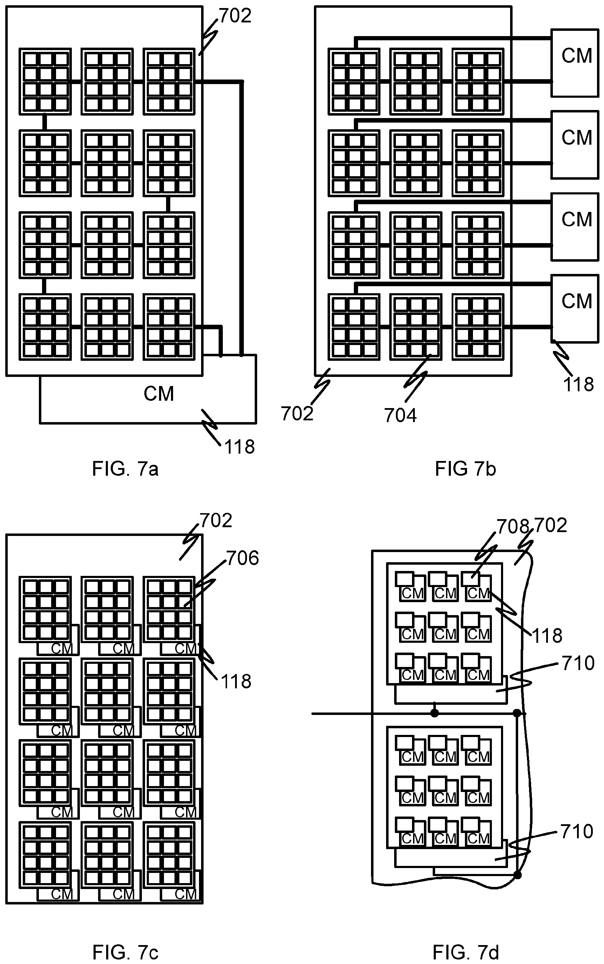

The roughest implementation level is an embodiment of a panel implementation (depicted in Fig. 7a), wherein each solar panel 702 forms one power source element and the network of power source elements is the network of solar panels. Thus, each solar panel is tracked separately and the energy produced in each solar panel is mixed by using the polyphase mixing technique described above. Although this embodiment only slightly improves the efficiency, it, however, is the most inexpensive solution for controlling the photovoltaic energy harvesting arrangement. The present embodiment utilizes complete standard solar panels, wherein the actual cells integrated in the panels are serially connected, which may produce relative high output voltage. High output voltages are preferable, because it may enable simper switch design and provide better efficiency due to smaller switching losses and losses in wires and traces. On the other hand, a system having low or medium voltage and low current may allow the ASIC (application-specific integrated circuit) implementation, as all components can be placed on silicon die.

In this application, solar panels can have high output voltage e.g. 48 V, 72 V or higher and mid current, e.g. about 4 A. With respect to SLA battery stacks, high voltage can be up to hundreds of volts and high current hundreds of amperes. Small solar panels and stacked panel components as well as small SLA stacks usually have mid voltage, i.e. from few volts to e.g. 24 V. Furthermore, PV-cells can have low voltage and mid current, such as e.g. 0,5 V and e.g. 4 A, as well as NiMH or LiPo/Li-Ion batteries having voltage up to few volts and current tens of amps at maximum.

Moreover, TEGs (thermoelectric generator, such as Peltier element), vibration harvesting equipment and such can have low voltage, e.g. to 20mV or even less, and low current. For instance, 1°C difference on Peltier element (TEG) would produce about 20mV.

Each solar panel, i.e. power source element, comprises a cell module 118. The converter in the cell module is preferably a buck converter, i.e. a step down converter, converting DC-current to a lower level. The buck converter is advantageous in this embodiment, because, due to the serially connected cell in the panel, the output of the power source element may have a moderate current level and a high voltage level.

The other embodiment is a string implementation (depicted in Fig. 7b), wherein each string of PV cells 704 in a solar panel forms one power source element and, respectively, comprises one cell module. In the present embodiment, partially shaded areas may not affect the total output energy of the present solar panel, which may improve the output efficiency the PV harvesting equipment. The number of strings in a solar panel may vary depending on solar panel type, for example, but normally there can preferably be e.g. about 2 - 50 strings, more preferably e.g. about 5 - 30 strings, and most preferably 8 - 16 strings in a panel. It is obvious to those skilled in the art, that the more strings the panel comprises, the higher is the achieved overall efficiency, because the number of the strings inversely correlates with the number of serially connected cells in a panel, and, thus, reduces the effect of partially shaded cells, for example.

The present embodiment can utilize standard solar panels, because normally standard solar panels comprise serially connected PV cells, from which the strings can be formed. The number of cells in a string can vary depending on embodiment, and a person skilled in art will appreciate that strings may comprise different number of solar cells in the same implementation.

In the present embodiment, each string, i.e. each power source element, comprises a cell module, and because of moderate output current and voltage of each power source element, the converter of the cell module can be e.g. a buck converter, i.e. a step-up converter, for the mixing of the energy to the inverter module.

Further, another embodiment is a cell implementation (depicted in Fig. 7c), wherein each PV cell 706 in a solar panel forms a power source element, and each power source element 706 is handled by separate cell module connected to it. A custom solar panel is required for this embodiment, because standard solar panels do not have separate outputs for cells. However, by utilizing this embodiment, it may be possible to achieve very high energy harvesting level.

The cell modules 118 should physically locate right next to the PV element to which it is connected for minimizing wire losses at the system, because PV elements in the present embodiment have a low voltage and a high current output. Furthermore, the used converter in the cell module 118 of the present embodiment is typically a step-up converter, i.e. a boost converter.

Yet, another embodiment is the most integrated the microcell implementation, wherein one or more microcell 708 of PV cell in a solar panel forms a PV element. In the present embodiment, the cell module 118 connected to the PV element requires preferably a semiconductor ASIC (Application Specific Integrated Circuit), which is mounted preferably right next to or on the back of the PV element. The microcells 708 comprising said ASICs can be mounted in a solar panel 702, which panel can be equipped with synchronizing means and can be connected directly to battery or inverter module.

The ASIC in the cell module of the present embodiment can comprise micro-synchronization controller 710 for synchronizing PV elements. Preferably, the micro-synchronization controller 710 is integrated in ASIC in order to save space. In a preferable embodiment, micro-sync controllers are arranged to check if others are active, and in case there are other cells active, they are arranged to shut themselves down for power conservation, leaving the first one to be a master and to control all cells. If the master has to shut down, because its cell has lost the power source, next master would be one with most powerful source at given moment. In another embodiment, all micro-synchronization controllers are active and form a synchronous chain of converters with power-sharing. A person skilled in the art will understand that the micro-synchronization controllers can also be arranged in some other way.

In one embodiment, the arrangement for controlling the power source system comprising PV cells can also be used as a solar tracking system or as a part of a solar tracking system for controlling the position of a solar panel. The arrangement of the present invention can act as light sensors of the tracking system, because each cell module provides the same information as a light sensor. Because the arrangement can detect shaded and partially shaded cells, the information provided by the arrangement can be utilized to turn the solar panel into an optimal position. In that case, the computer program/software can comprise algorithms to distinguish clouds from the sun movement. It is advantageous to utilize PV cells for solar tracking, because such sensor will have exact the same angle and alignment as PV cell, provding "perfect" readings, of course, as the light sensing is done by using the calculated values from realtime measured I and V on PV cell itself.

The solar tracking is performed by scanning the power level of the power source element and by calculating the data at the same switching frequency. This may allow not only to track sun, but to distinguish various kinds of shadings, going as far as recreating the cloud motion images and animation form the data gathered at this speed and digitally filtered.

## Claims

1. A control arrangement for a power source system comprising a number of power source elements (116, 702, 704, 706, 708) arranged to provide energy, wherein said arrangement comprises:
- a number of cell modules (110, 118) for transferring energy provided by power source elements (116, 702, 704, 706, 708), wherein one cell module is functionally connected to one power source element,
- control means (104) for controlling energy transfer from power source elements (116, 702, 704, 706, 708),
- monitoring means (202) for real time monitoring the energy level in each power source element (116, 702, 704, 706, 708), and
- synchronizing and power converting means (204) for synchronizing energy output of the power source element (116, 702, 704, 706, 708) with energy outputs of the other power source elements in a network, **characterised in that** each power source element (116, 702, 704, 706, 708) is integrated, via the respective cell module (110, 118), with said synchronizing and power converting means (204) such, that one cell module (110, 118) is connected to the synchronization means (204) at a time, and wherein the control means (104) is arranged to obtain information related to the energy level in the power source element and to perform energy transfer from the power source element, if the energy level in the power source element exceeds a threshold value.

2. The control arrangement for a power source system according to claim 1, wherein the power source element (116, 702, 704, 706, 708) is selected from the group consisting of: a rechargeable battery / batteries, a non-rechargeable battery/batteries, a supercapacitor / supercapacitors, an ultracapacitor / ultracapacitors, an energy harvesting unit / units based on energy harvesting from wind, sun, moisture, electromagnetic field, vibration, heat, fluid flow, mechanical motion and/or rotation, and any combination of listed above.

3. The control arrangement for a power source system according to claim 1, wherein the power source element (116, 702, 704, 706, 708) comprises an at least one photovoltaic element selected from the group consisting of: a solar panel, a string of individual photovoltaic cells in a solar panel, an individual photovoltaic cell in a solar panel, and a micro-cell comprised within the photovoltaic cell in a solar panel.

4. The control arrangement for a power source system according to any preceding claim, wherein said threshold value for the energy level in the power source element is equal to or exceeds the energy consumption value of said power source element.

5. The control arrangement for a power source system according to any preceding claim, wherein the monitoring means (202) is disposed in said control means (104).

6. The control arrangement for a power source system according to any of the claims 1-4, wherein the monitoring means (202) is disposed in each cell module (110, 118).

7. The control arrangement for a power source system according to any preceding claim, wherein the real-time measurement of the energy level in the power source element (116, 702, 704, 706, 708) comprises simultaneous voltage and current measurements.

8. The control arrangement for a power source system according to any preceding claim, wherein energy transfer from the power source element (116, 702, 704, 706, 708) proceeds as long as the energy level in the power source element exceeds the threshold value.

9. The control arrangement for a power source system according to any of the claims 1-7, wherein energy transfer from the power source element (116, 702, 704, 706, 708) proceeds within a predetermined time period, if the energy level in the power source element exceeds the threshold value.

10. The control arrangement for a power source system according to any preceding claim, wherein numerous power source elements in said arrangement is used as a light sensor of a solar tracking system for a solar panel.

## Patentansprüche

1. Steueranordnung für ein Stromquellensystem, das mehrere Stromquellenelemente (116, 702, 704, 706, 708) umfasst, die dazu angeordnet sind, Energie bereitzustellen, wobei die Anordnung umfasst:
- mehrere Zellenmodule (110, 118) zum Übertragen von Energie, die durch die Stromquellenelemente (116, 702, 704, 706, 708) bereitgestellt wird, wobei ein Zellenmodul funktionell mit einem Stromquellenelement verbunden ist,
- Steuermittel (104) zum Steuern der Energieübertragung von den Stromquellenelementen (116, 702, 704, 706, 708),
- Überwachungsmittel (202) zum Echtzeitüberwachen des Energieniveaus in jedem Stromquellenelement(116, 702, 704, 706, 708) und
- Synchronisierungs- und Stromwandlungsmittel (204) zum Synchronisieren der Energieabgabe des Stromquellenelements (116, 702, 704, 706, 708) mit Energieabgaben der anderen Stromquellenelemente in einem Netzwerk,
**dadurch gekennzeichnet, dass**
jedes Stromquellenelement (116, 702, 704, 706, 708) über das entsprechende Zellenmodul (110, 118) mit dem Synchronisierungs- und Stromwandlungsmittel (204) derart integriert ist, dass jeweils ein Zellenmodul (110, 118) mit dem Synchronisierungsmittel (204) verbunden ist, und wobei das Steuermittel (104) dazu angeordnet ist, Informationen bezüglich des Energieniveaus in dem Stromquellenelement zu erhalten und eine Energieübertragung von dem Stromquellenelement durchzuführen, wenn das Energieniveau in dem Stromquellenelement einen Schwellenwert überschreitet.

2. Steueranordnung für ein Stromquellensystem nach Anspruch 1, wobei das Stromquellenelement (116, 702, 704, 706, 708) ausgewählt ist aus der Gruppe bestehend aus: (einer) wiederaufladbaren Batterie/Batterien, (einer) nicht wiederaufladbaren Batterie/Batterien, (einem) Superkondensator/Superkondensatoren, (einem) Ultrakondensator/Ultrakondensatoren, (einer) Energiegewinnungseinheit/-einheiten, die auf einer Energiegewinnung aus Wind, Sonne, Feuchtigkeit, einem elektromagnetischen Feld, Schwingung, Wärme, einem Strömen von Fluid, mechanischer Bewegung und/oder Drehung basiert/en, und jeder Kombination der vorgenannten.

3. Steueranordnung für ein Stromquellensystem nach Anspruch 1, wobei das Stromquellenelement (116, 702, 704, 706, 708) ein mindestens ein photovoltaisches Element umfasst, ausgewählt aus der Gruppe bestehend aus: einem Solarpanel, einer Kette einzelner photovoltaischer Zellen in einem Solarpanel, einer einzelnen photovoltaischen Zelle in einem Solarpanel und einer Mikrozelle, die in der photovoltaischen Zelle in einem Solarpanel enthalten ist.

4. Steueranordnung für ein Stromquellensystem nach einem vorhergehenden Anspruch, wobei der Schwellenwert für das Energieniveau in dem Stromquellenelement gleich dem Energieverbrauchswert des Stromquellenelements ist oder diesen überschreitet.

5. Steueranordnung für ein Stromquellensystem nach einem vorhergehenden Anspruch, wobei das Überwachungsmittel (202) in dem Steuermittel (104) angeordnet ist.

6. Steueranordnung für ein Stromquellensystem nach einem der Ansprüche 1 - 4, wobei das Überwachungsmittel (202) in jedem Zellenmodul (110, 118) angeordnet ist.

7. Steueranordnung für ein Stromquellensystem nach einem vorhergehenden Anspruch, wobei die Echtzeitmessung des Energieniveaus in dem Stromquellenelement (116, 702, 704, 706, 708) gleichzeitige Spannungs- und Strommessungen umfasst.

8. Steueranordnung für ein Stromquellensystem nach einem vorhergehenden Anspruch, wobei die Energieübertragung von dem Stromquellenelement (116, 702, 704, 706, 708) stattfindet, solange das Energieniveau in dem Stromquellenelement den Schwellenwert überschreitet.

9. Steueranordnung für ein Stromquellensystem nach einem der Ansprüche 1 - 7, wobei die Energieübertragung von dem Stromquellenelement (116, 702, 704, 706, 708) in einem vorgegebenen Zeitraum stattfindet, wenn das Energieniveau in dem Stromquellenelement den Schwellenwert überschreitet.

10. Steueranordnung für ein Stromquellensystem nach einem vorhergehenden Anspruch, wobei zahlreiche Stromquellenelemente in der Anordnung als Lichtsensor eines Solarnachführsystems für ein Solarpanel benutzt werden.

## Revendications

1. Agencement de régulation pour un système de source d'alimentation comprenant un nombre d'éléments de source d'alimentation (116, 702, 704, 706, 708) agencés pour fournir de l'énergie électrique, dans lequel ledit agencement comprend :
- un nombre de modules de cellules (110, 118) pour transférer l'énergie fournie par les éléments de source d'alimentation (116, 702, 704, 706, 708), dans lequel un module de cellules est connecté fonctionnellement à un élément de source d'alimentation,
- un moyen de régulation (104) pour réguler le transfert d'énergie à partir des éléments de source d'alimentation (116, 702, 704, 706, 708),
- un moyen de surveillance (202) pour surveiller en temps réel le niveau d'énergie dans chaque élément de source d'alimentation (116, 702, 704, 706, 708) et
- un moyen de synchronisation et conversion de puissance (204) pour synchroniser la sortie d'énergie de l'élément de source d'alimentation (116, 702, 704, 706, 708) avec des sorties d'énergie des autres éléments de source d'alimentation dans un réseau,
**caractérisé en ce que**
chaque élément de la source d'alimentation (116, 702, 704, 706, 708) est intégrée, via ledit module de cellule respectif (110, 118), avec ledit moyen de synchronisation et conversion de puissance (204), de sorte qu'un module de cellule (110, 118) soit connecté au moyen de synchronisation (204) à la fois et dans lequel le moyen de régulation (104) est agencé afin d'obtenir une information relative au niveau d'énergie dans l'élément de source d'alimentation et effectuer un transfert d'énergie à partir de l'élément de source d'alimentation, si le niveau d'énergie dans l'élément de source d'alimentation excède une valeur seuil.

2. Agencement de régulation pour un système de source d'alimentation selon la revendication 1, dans lequel l'élément de source d'alimentation (116, 702, 704, 706, 708) est sélectionné parmi le groupe constitué de : une batterie/des batteries rechargeables, une batterie/des batteries non rechargeables, un supercondensateur/ des supercondensateurs, un ultracondensateur/des ultracondensateurs, une unité/des unités de récupération d'énergie basée sur la récupération d'énergie à partir du vent, soleil, humidité, champ électromagnétique, vibration, chaleur, écoulement de fluide, mouvement mécanique et/ou rotation et n'importe quelle combinaison des éléments listés ci-dessus.

3. Agencement de régulation pour un système de source d'alimentation selon la revendication 1, dans lequel l'élément de source d'alimentation (116, 702, 704, 706, 708) comprend au moins un élément photovoltaïque sélectionné dans le groupe situé de : un panneau solaire, une chaîne de cellules photovoltaïques individuelles dans un panneau solaire, une cellule photovoltaïque individuelle dans un panneau solaire et une micro cellule comprise à l'intérieur de la cellule photovoltaïque dans un panneau solaire.

4. Agencement de régulation pour un système de source d'alimentation selon une quelconque des revendications précédentes, dans lequel ladite valeur seuil pour le niveau d'énergie dans l'élément de source d'alimentation est égale à ou excède la valeur de consommation d'énergie dudit élément de source d'alimentation.

5. Agencement de régulation pour un système de source d'alimentation selon une quelconque des revendications précédentes, dans lequel le moyen de surveillance (202) est disposé dans ledit moyen de régulation (104).

6. Agencement de régulation pour un système de source d'alimentation selon une quelconque des revendications 1 - 4, dans lequel le moyen de surveillance (202) est disposé dans chaque module de cellule (110, 118).

7. Agencement de régulation pour un système de source d'alimentation selon une quelconque des revendications précédentes, dans lequel la mesure en temps réel du niveau d'énergie dans l'élément de source d'alimentation (116, 702, 704, 706, 708) comprend des mesures de tension et de courant simultanées.

8. Agencement de régulation pour un système de source d'alimentation selon une quelconque des revendications précédentes, dans lequel le transfert d'énergie à partir de l'élément de source d'alimentation (116, 702, 704, 706,708) continue tant que le niveau d'énergie dans l'élément de source d'alimentation excède la valeur seuil.

9. Agencement de régulation pour un système de source d'alimentation selon une quelconque des revendications 1 - 7, dans lequel le transfert d'énergie à partir de l'élément de source d'alimentation (116, 702, 704, 706, 708) continue en l'espace d'une période de temps prédéterminée, si le niveau d'énergie dans l'élément de source d'alimentation excède la valeur seuil.

10. Agencement de régulation pour un système de source d'alimentation selon une quelconque des revendications précédentes, dans lequel plusieurs éléments de source d'alimentation dans ledit agencement sont utilisés comme un capteur de lumière d'un système de suivi solaire pour un panneau solaire.
